(19) Europäisches Patentamt
European Patent Office
Office eurcpéen des brevets

(11) Publication number: 0 249 306 A2

# (12) EUROPEAN PATENT APPLICATION

(21) Application number: 87302184.4

(51) Int. Cl.⁴: C08F 8/30

(22) Date of filing: 13.03.87

(30) Priority: 10.05.86 GB 8611454

(43) Date of publication of application:
16.12.87 Bulletin 87/51

(84) Designated Contracting States:
BE CH DE FR GB IT LI LU NL

(71) Applicant: AUTOTYPE INTERNATIONAL LIMITED
Grove Road
Wantage Oxon OX12 7BZ(GB)

(72) Inventor: Balfour, Ross Alexander
36 Mallard Way Grove
Wantage Oxon OX12 0QQ(GB)
Inventor: Sperry, John Arthur
41 norman Avenue Abingdon
Oxon OX14 2HJ(GB)
Inventor: Woolrich, Brian
26 Woodgate Close Grove
Wantage Oxon OX12 0NG(GB)

(74) Representative: Oliver, Roy Edward et al
POLLAK MERCER & TENCH High Holborn
House 52-54 High Holborn
London WC1V 6RY(GB)

## (54) Polymeric materials containing unsaturated groups.

(57) Polymeric materials containing unsaturated groups consist of polyvinyl alcohol, i.e. the product of at least partial hydrolysis of polyvinyl acetate, in which some of the -OH groups have been converted to ether-linked unsaturated groups derived from methylolacrylamide.



Xerox Copy Centre

# POLYMERIC MATERIALS CONTAINING UNSATURATED GROUPS

This invention is concerned with the preparation of water-soluble polymeric materials containing unsaturated groups capable of polymerisation.

Photosensitive resin compositions have long been used in such applications as the preparation of various types of printing plates, as resists for subsequent plating or etching operations in the preparation of printed circuit boards, and in the manufacture of UV-curable inks and varnishes.

Water-soluble or water-processable resist materials are very desirable, because of their cheapness and safe handling properties, at the preparation stage, and the subsequent ease of processing, after exposure to actinic light. Water-soluble polymers can be used in these applications, usually after their admixture with suitable low molecular weight unsaturated molecules capable of vinyl polymerisation, together with a photoini tiator capable of giving free radicals and causing polymerisation of the unsaturated compound. If the molecule contains more than one unsaturated group, cross-linking can occur. The inert polymer becomes trapped in a matrix of cross-linked polymer, thus increasing the efficiency of the photoreaction. The "polymerising system" can be wholly dissolved in the water solution of colloid, as described in GB-PS 1,307,995 or it may be insoluble but capable of dispersion in the aqueous collodial solution, by the use of suitable surfactants together with high speed agitation, as described in GB-PS 2,109,392.

To increase the efficiency of the reaction, it is very desirable that the high molecular weight water-soluble polymer should contain available unsaturated groups, capable of participating in the polymerisation reaction. When such groups are available, during the reaction the polymer chains themselves crosslink, the molecular weight rises very rapidly and the efficiency of the photoreaction is greatly increased.

One of the most readily-available and useful water-soluble polymers is so-called polyvinyl alcohol, namely the product obtained by the hydrolysis of polyvinyl acetate. The hydrolysis reaction may be allowed to go to completion or it may be terminated at an intermediate stage. Therefore, polyvinyl alcohol of commerce may contain a greater or lesser proportion of acetate groups. It is also available in a range of molecular weight grades. Polyvinyl alcohol is particularly attractive, because it is very resistant to the usual organic solvents and yet may readily be removed when required by the application of an aqueous periodate solution. This offers a very versatile combination of properties useful for many applications.

It is normally very difficult to convert the hydroxyl groups of polyvinyl alcohol into derivatives via an ester or ether linkage. Because of the insolubility of polyvinyl alcohol in normal organic solvents and its solubility only in water or water-solvent mixtures, the use of normal acylating agents such as acid chlorides or anhydrides is precluded, as these react preferentially with the water.

The difficulties mentioned above are illustrated by reference to polyvinyl cinnamate, for example. This product is normally prepared by first swelling polyvinyl alcohol with pyridine and then reacting the product with cinnamyl chloride. This is an expensive and inconvenient route, requiring the handling and recovery of pyridine.

In another procedure, the reaction is carried out in a solvent for polyvinyl alcohol, such as N-methyl-pyrrolidone. As with most reactions involving polymers, the product is recovered by the introduction of a nonsolvent in many times excess, so as to precipitate the modified polymer. The product may have to be redissolved and reprecipitated several times to remove impurities. This is also an expensive process, involving solvent recovery etc.

According to one aspect of this invention, therefore, a water-soluble polymer containing unsaturated groups and capable of undergoing photoinitiated polymerisation is characterised by containing ether-linked unsaturated groups of the formula:

$$\{\ CH_2-\underset{\textstyle |}{CH}-CH_2\ \}$$
$$O-CH_2.NH.CO.CH=CH_2.$$

The polymer of the invention is readily obtainable from available materials and, for instance, is the product obtained by reacting polyvinyl alcohol in the form of a suspension in a non-solvent with N-methylolacrylamide.

The invention also residues in a method of manufacture of the polymer per se, wherein polyvinyl alcohol in the form of a suspension in a non-solvent is contacted with N-methylolacrylamide in the presence of an acid catalyst for a time sufficient to replace hydroxyl groups in the polyvinyl alcohol with ether-linked unsaturated groups of the formula:

$$\{ CH_2-\underset{|}{C}H-CH_2 \}$$
$$O-CH_2.NH.CO.CH=CH_2.$$

Preferably, the reaction is carried out so that up to 25% of the hydroxyl groups in the polyvinyl alcohol are replaced by unsaturated groups of the formula.

This invention is based upon the surprising discovery that if the polyvinyl alcohol is used as a finely-powdered grade, it may be dispersed in a non-solvent and the reaction carried out heterogeneously. If methylolacrylamide is used as the co-reactant in the presence of an acid catalyst, the water formed during ether formation may be removed azeotropically and the reaction carried out with great efficiency. The etherified product is simply filtered off at the end of the reaction, washed with a suitable non-solvent and dried. The problems of handling polymer solutions and recovering the product are thus obviated, and the process provides a cheap convenient way of producing modified polyvinyl alcohol, suitable for example for use in preparation of highly photo-efficient photoresists. The product may also be used for many other applications, such as in soil modification, and in particular in UV-curable, water-containing inks.

The polyvinyl alcohol may be any grade of fully or partially-hydrolysed polyvinyl acetate, i.e. it may contain a proportion of acetate groups. Any powder grade may be used, but it has been found that the best results are obtained from powder passing an 80-mesh sieve, i.e. below 175 microns (μm).

Although not limiting, 0.1% to 10% of acid by weight of methylolacrylamide is preferred.

A small amount of stabilizer such as hydroquinone may be added to prevent polymerisation of the methylolacrylamide. For the same reason, the temperature of the reaction mixture should preferably be not more than 85°C and, at best, about 75°C. It may be desirable to reduce the pressure over the reaction mixture, so that azeotropic removal of the water takes place efficiently without allowing the temperature to rise above 80°-85°C. A suitable non-solvent for the reaction is toluene.

In order that the invention may be fully understood and appreciated, the following non-limitative Examples are given, by way of illustration. Proprietary products used in these Examples are described in detail at the end.

## EXAMPLE 1

### Synthesis of acrylamide-grafted polyvinyl alcohol

The following reactants were charged to a 1 litre reaction vessel equipped with an efficient stirrer:

Polyvinyl alcohol ("Gohsenol" GH-17S) 150.0 g
Trichloracetic acid (acid catalyst) 1.5 g
Hydroquinone (radical inhibitor) 0.3 g
Toluene 700.0 ml

The mixture of reactants was stirred and the temperature was raised to 75°C. N-Hydroxymethylacrylamide (NMA) (17 g) was then added and the reaction was allowed to proceed for 1 hour, while ensuring continuing thorough agitation of the slurry. At the end of this time, solid acrylamide-grafted polyvinyl alcohol derivative was recovered by filtration. Thorough washing with several 500 ml portions of ethanol at 50°C was carried out, in order to remove any impurities. After drying, 160 g of etherified reaction product was recovered.

Kjeldahl nitrogen analysis showed the presence of ~8% w/w grafted acrylamide.

## EXAMPLE 2

The acrylamide-grafted polyvinyl alcohol ("Modified PVOH") obtained as described in Example 1 was incorporated into the following photosensitive composition:

Solution A
Modified PVOH 050.0 g
Water 400.0 g
Monoacetin 018.0 g

Solution B
Pentaerythritol triacrylate 050.0 g
Dibutyl phthalate 005.0 g
"Quantacure" ITX 002.5 g
"Quantacure" EPD 005.0 g

Solutions A and B were formed separately and then blended on a high shear mixer for ~2 minutes. Then, 1 g of "Unisperse Green GP" pigment dispersion was added and the whole mixture was blended for a further 2 mins. The resultant emulsion was coated on to both sides of a 90 threads per cm, amber-coloured screen printing mesh and dried with warm air.

After exposure to a photographic positive with actinic light and water development, a tough negative image was obtained, which was eminently suitable for use as a stencil, as it exhibited good resistance to all solvents normally used in screen printing inks. After printing, it was easily removed from the screen printing mesh, by application of an aqueous periodate solution.

Comparative Example 3

A composition was prepared and processed as in Example 2, except that Gohsenol GH-17S was used in place of the modified PVOH and 1.2 g of N,N, methylene-bis-acrylamide was used as a water-soluble polymerisible monomer. This experiment thus used the same polyvinyl alcohol as in Example 1, but without subjecting it to acrylamide grafting as in accordance with the invention. This formulation using unmodified PVOH yielded a weak negative image, which was easily damaged during wet development.

In the foregoing Examples:
"Gohsenol" is a Regd. Trademark of Nippon Gohsei and "Gohsenol GH-17S" is a finely-sieved grade of polyvinyl alcohol powder having the following characteristics:
degree of saponification : 88 mole %
degree of polymerisation " 1,700
viscosity of 4% aq. solution: 30 CP;
"Quantacure" is a Regd. Trademark of Ward Blenkinsop & Co. Ltd. and
"Quantacture ITX" and "Quantacure EPB" are respectively (a) a mixture of the 2-and 4-isomers of isopropylthioxanthone and (b) ethyl-4-dimethylaminobenzoate;
"Unisperse" is a Regd. Trademark of Ciba Geigy and "Unisperse Green GP" is a nonionic pigment dispersion containing 50% solids.

## Claims

1. A water-soluble polymer containing unsaturated groups and capable of undergoing photoinitiated polymerisation,
characterised by
containing ether-linked unsaturated groups of the formula:

$$\begin{array}{l}\{\, CH_2-\underset{|}{CH}-CH_2 \,\} \\ \qquad\quad O-CH_2.NH.CO.CH = CH_2.\end{array}$$

2. A water-soluble polymer containing unsaturated groups and capable of undergoing photoinitiated polymerisation,
characterised by
comprising the product obtained by reacting polyvinyl alcohol in the form of a suspension in a non-solvent with N-methylolacrylamide.

3. A polymer according to claim 1 or 2, which comprises polyvinyl alcohol having up to 25% of its hydroxyl groups substituted by groups of the formula $-OCH_2.NH.CO.CH=CH_2$.

4. A polymer according to claim 1, 2 or 3, which comprises polyvinyl alcohol derived by first hydrolysing at least 70% of the available acetate groups of polyvinyl acetate and then subjecting the hydrolysis product to modification.

5. A method of manufacture of a water-soluble polymer containing unsaturated groups and capable of undergoing photoinitiated polymerisation,
characterised in that
polyvinyl alcohol in the form of a suspension in a non-solvent is contacted with N-methylolacrylamide in the presence of an acid catalyst for a time sufficient to replace hydroxyl groups in the polyvinyl alcohol with ether-linked unsaturated groups of the formula:

$$\begin{array}{l}\{\, CH_2-\underset{|}{CH}-CH_2 \,\} \\ \qquad\quad O-CH_2.NH.CO.CH = CH_2.\end{array}$$

6. A method according to claim 5, wherein the reaction is carried out so that up to 25% of the hydroxyl groups in the polyvinyl alcohol are replaced by unsaturated groups of the formula.

7. A method according to claim 5 or 6, wherein the polyvinyl alcohol is derived by first hydrolysing at least 70% of the available acetate groups of polyvinyl acetate and then subjecting the hydrolysis product to the reaction with N-methylolacrylamide.

8. A method according to claim 5, 6 or 7, wherein the polyvinyl alcohol comprises a powder passing an 80-mesh sieve, the acid catalyst is used in an amount in the range from 0.1% to 10% by weight of the N-methylolacrylamide and the reaction is carried out at a temperature of not more than 85°C.

9. A method according to claim 8, wherein the acid catalyst comprises trichloracetic acid, the non-solvent is toluene and the reaction is carried out at a temperature of about 75°C.

10. A method of manufacture of a photosensitive composition or a product comprising such a composition, wherein the composition contains as the photo-sensitive component a water-soluble polymer containing unsaturated groups and based upon polyvinyl alcohol,
characterised in that
the polymer contains ether-linked unsaturated groups of the formula:

$$\begin{array}{l}\{\, CH_2-\underset{|}{CH}-CH_2 \,\} \\ \qquad\quad O-CH_2.NH.CO.CH = CH_2.\end{array}$$

11. A method according to claim 10, wherein the polymer comprises the product by reacting polyvinyl alcohol in the form of a suspension in a non-solvent with N-methylolacrylamide.

12. A photosensitive composition or a product comprising such a composition, wherein the photosensitive component comprises a water-soluble polymer containing unsaturated groups and based upon polyvinyl alcohol, characterised in that
the polymer contains ether-linked unsaturated groups derived by substituting up to 25% of the hydroxyl groups present in the polyvinyl alcohol by reaction with N-methylolacrylamide.